# EUROPEAN PATENT APPLICATION

(11) **EP 4 576 097 A1**
(43) Date of publication of application: **25.06.2025**
(21) Application number: 23307289.1
(22) Date of filing: 20.12.2023
(51) Int. Cl.: G11C 16/22, G11C 16/26, G11C 7/24

(54) **SECURE NON-VOLATILE MEMORY**

(71) Applicant: THALES DIS FRANCE SAS, 92190 Meudon (FR)
(72) Inventor: NAURA, David, 13100 Aix en Provence (FR); GIOVINAZZI, Thierry, 83470 Saint Maximin La Sainte Baume (FR)
(74) Representative: Bricks, Amélie

(57) **Abstract**

The invention relates to a method for detecting a reading error caused by a photoelectric or radiative attack of a non-volatile memory having memory cells (MCj,i) connected to at least one bit line (BLi), and comprising each a floating gate transistor, wherein the reading of a memory cell (MCj,i) is made by precharging a bit line (BLi) to a preload voltage and comparison of the bit line voltage to this preload voltage after a reading time during which a selected cell (MCj,i) charges or discharges the bit line (BLi) polarized by a constant current, the constant current being provided by a reference generator (320), characterized in that the detection of the photoelectric or radiative attack is made by a monitoring of the constant current, and wherein an alarm signal (ALARM) is provided when an abnormal constant current is detected.

## Description

### Technical Field

The invention relates to a secure non-volatile memory and more particularly non-volatile memory using floating gate transistor.

### Background Art

Non-volatile memories are commonly used for memorizing information without power supply. Amongst the different categories of non-volatile memories, memories with floating gate transistor allow to be programmable and erasable, like Flash memories or EEPROMs (Electrically Erasable Programmable Read Only Memory).

One use of Flash or EEPROM memories is storing security data, in particular passwords but also secure programs for making strong authentications. Such kind of memories is commonly used in many products using secure element like smart cards, smartphones, computers, or any communicating electronic device that should be securely connected. Typically, such kind of memories are embedded in a microcontroller component making a verification of password in such a way the password never goes out of the component. Nevertheless, there are some methods for retrieving the password from such a component.

One method consists in a direct access to the memory after removing protection resin from the component. Once the memory is naked, the memory can be accessed by thin probe or by laser. In such a way to avoid a direct reading of the memory, the memory can be scrambled or encoded.

Even if the memory is scrambled or encoded, a method, known as "fault attack", consists in altering the reading of the memory in such a way to cause some faults during the running of a secure program for locating where the sensitive data are.

For compact memories, it is known to place bit line decoder between the read amplifiers and the memory cells in such a way to reduce the number of read amplifiers. Such an architecture increases the resistance of the bit line and it is preferred to have bit lines polarized at a constant current, the reading being made after a preload of the bit line at an intermediate voltage. So, the state of a selected memory cell enables a charging or a discharging of the bit line that can be compared to the preload voltage after a certain time. In such memories, the fault introduction can be made by laser on the circuit generating the reference current used for reading the cell. A laser attack on the reference current generator can significantly increase or decrease the reference current causing an error reading. Today, there exist some protection circuits for detecting a laser attack on the memory cells, but such kind of attack detector cannot detect an attack made on the circuit generating the reference current. There is a need to detect such an attack for stopping the running of a secure program.

### Summary of the Invention

The invention provides a memory comprising a circuit for raising an alarm in case of detection of a laser attack on the circuit generating the reference current used for reading memory Cells. Such alarm can then be used for rebooting a microcontroller causing the aborting of the current running program.

More particularly, the invention provides a method for detecting a reading error caused by a photoelectric or radiative attack of a non-volatile memory having memory cells connected to at least one bit line, and comprising each a floating gate transistor, wherein the reading of a memory cell is made by pre-charging a bit line to a preload voltage and comparison of the bit line voltage to this preload voltage after a reading time during which a selected cell charges or discharges the bit line polarized by a constant current, the constant current being provided by a reference generator. The detection of the photoelectric or radiative attack is made by a monitoring of the constant current, and wherein an alarm signal is provided when an abnormal constant current is detected.

Preferentially, the monitoring of the constant current can be made by a comparison of the constant current with a high current threshold and with a low current threshold, the low current threshold being lower than the high current threshold and wherein the alarm signal is provided when the constant current is not comprised between the high current threshold and the low current threshold. The invention also provides a non-volatile memory circuit comprising a plurality of memory cells, a plurality of bit lines and a plurality of word lines, each memory cell comprising a floating gate transistor for memorizing a bit value and being located at the intersection of a bit line and of a word line, said non-volatile memory circuit comprising a polarization circuit for polarizing the bit lines with a constant current, a reference generator providing a reference signal to the polarization circuit for generating the constant current, and reading amplifiers connected to bit lines for reading the value of memory cells selected by one of the word lines. The non-volatile memory further comprises an attack detector comprising at least one detection circuit having an input terminal receiving the reference signal to monitor the constant current and for providing an alarm signal on an output terminal when the reference signal indicates that the constant current corresponds to an abnormal constant current.

Preferentially, the polarization circuit can comprise at least one mirror transistor having a gate receiving the reference signal and a channel connected to the bit line for providing the constant current, wherein the detection circuit comprises at least one copy transistor identical to the mirror transistor for reproducing the constant current. The detection circuit can be configured for comparing the constant current with a high current threshold and with a low current threshold, the low current threshold being lower than the high current threshold. The alarm signal can be provided when the constant current is not comprised between the high current threshold and the low current threshold.

According to a specific embodiment, the detection circuit can comprise two copy transistors and first and second comparator circuits, each of the first and second comparator circuits being connected to one of the copy transistors. The first comparator circuit can compare the constant current with the low current threshold while the second comparator circuit can compare the constant current with the high current threshold.

The detection circuit can comprise a logic gate having two inputs and one output, the two inputs being respectively connected to the outputs of the comparator circuits, and the output providing the alarm signal when the first comparator circuit indicates that the constant current is lower than the low current threshold or when the second comparator circuit indicates that the constant current is higher than the high current threshold.

Preferentially, the detection circuit can be located far from the reference circuit.

For improving the robustness, the attack detector can comprise two detection circuits. The output signals of the detection circuits can be complementary. Each of the detection circuits can be located far from the reference circuit, and the detection circuits can be located far from each other.

### Brief description of the Drawings

The invention will be detailed with reference to the annexed drawings in which:
Figure 1 shows a microcontroller type circuit including a non-volatile memory,
Figure 2 shows a first structure of a non-volatile memory circuit according to the invention,
Figure 3 details a part of a bit line during a reading operation,
Figure 4 shows a timing diagram of a reading operation in normal condition,
Figure 5 details an attack detector according to the invention,
Figure 6 details a variant of an attack detector according to the invention.

### Detailed Description of the invention

In such a way to simplify the present specification, a same reference is used on different drawings for designing a same element or an equivalent element. In addition, only parts of the memory are shown on the drawings for avoiding a surcharge that may render the drawings unreadable. Timing diagrams are not made with an exact scale for showing details that cannot be shown otherwise.

In the present document, it will be made reference to active signal, inactive signal, high level, low level, level "1" and level "0". As well known by a person skilled in the art, levels "0" and "1" and a low or a high level can arbitrarily correspond to an active and inactive levels depending on the kind of transistor used or of a simple choice of the designer. So, changing a high level to a low level or a level "1" to a level "0" has no importance in relation with the invention.

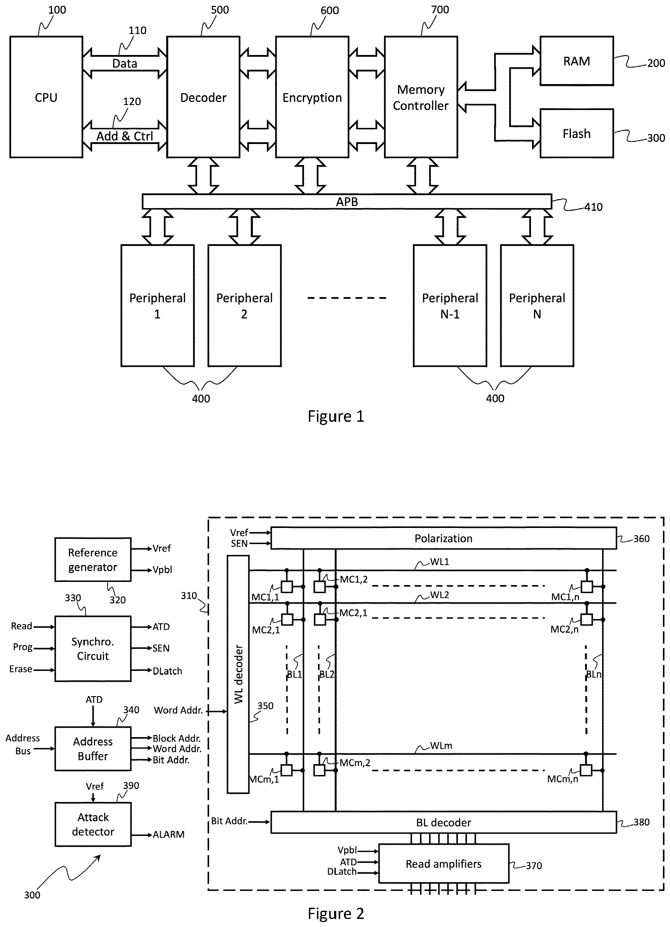

The invention is related to the security of a non-volatile memory. Such non-volatile memories are generally included in a microcontroller circuit that can be also known as System-On-Chip (SOC). As an example, a microcontroller is shown on figure 1 for showing the context of use of a memory according to the invention. The microcontroller of figure 1 comprises a central processing unit (CPU) 100 that may include one or more microprocessor cores. The CPU 100 comprises a data bus 110, and an address and control bus 120 for communicating with memories 200 and 300 and with peripheral units 400. For securely managing the memories 200 and 300 or the peripheral units 400, the microcontroller can comprise a decoder circuit 500, an encryption circuit 600 and a memory controller 700, both connected to the data bus 110 and the address and control bus 120 and to an application peripheral bus 410 for connecting the peripheral units 400.

Typically, control signals and address format depend on the memory type, and it is necessary to adapt them to be transparent for the CPU. The memory controller 700 can be used for addressing each memory 200 or 300 with address and control signals adapted to each type of memory that can be volatile memory 200, for example of RAM type, or non-volatile memory, for example of Flash type.

The encryption circuit 600 can be used for secure circuit, it can be of different types and can be controlled by the CPU for encrypting the data transmitted to the memories or to the peripheral units or for scrambling the addresses of the data into one memory. The encryption circuit 600 can be also transparent if no security is required for the transferred data.

The decoder circuit 500 can be used for decoding some control signals of the CPU in such a way to address the memories 200 or 300, one peripheral unit 400, or to control the encryption circuit 600 or for establishing a data transfer between one of the memories 200 or 300 and one peripheral unit 400, eventually through the encryption circuit 600.

Many other architectures are possible using different communication paths between a CPU, its memories, and its peripherals units. Figure 1 showing only one example amongst many other possibilities, many functional variants of the decoder circuit 500, the encryption circuit 600, and the memory controller 700 are possible and they can be also optional. For the invention, one important thing is that a CPU 100 is connected directly or indirectly to a non-volatile memory 300 in view to read data that can be encrypted or scrambled or not. According to the invention the non-volatile memory 300 is capable to send a signal to the CPU 100 for indicating when an attack has been made during a reading operation.

The figure 2 illustrates an example of a non-volatile memory 300 according to the invention, for example a Flash memory, having a size that is small enough to be implemented into a SOC. The memory 300 can comprise one or more memory blocks 310 but only one is represented for simplifying the drawing. The memory further comprises a reference generator 320, a synchronization circuit 330 and an address buffer 340 for synchronizing the memory. For simplification reasons, only signals used for a reading operation are indicated on the drawing.

The memory block 310 comprises a plurality of word lines WL1 to WLm, a plurality of bit lines BL1 to BLn and a plurality of memory cells MC1,1 to MCm,n, each memory cell MCj,i being located and connected at the intersection of one word line WLj with one bit line BLi. The memory block 310 further comprises a word line decoder 350, a polarization circuit 360, read amplifiers 370, a bit line decoder 380 and an attack detector 390.

The reference generator 320 provides a first reference voltage Vref and a second reference voltage Vpbl. The reference generator 320 contains a stabilized current source and the first reference voltage Vref corresponds to the intermediate voltage of a current mirror which is provided to the polarization circuit 360 for enabling the polarization circuit 360 to mirror and to provide this stabilized current to each bit line BL1 to BLn in such a way to polarize said bit lines BL1 to BLn with a constant current. The second reference voltage Vpbl corresponds to a preload voltage of the bit line used for starting each reading operation.

The synchronization circuit 330 receives the external control signals provided by the memory controller 700 which correspond to a reading signal Read, a programing signal Prog and an erasing signal Erase. Each of these signals Read, Prog and Erase triggers a sequence of signals to the different circuits constituting the memory circuit 300 for providing the requested operation. In the present specification, only the signals used for a reading operation will be detailed. The activation of the reading signal Read triggers an address validation signal ATD, a sensing signal SEN, and a data latching signal Dlatch with timing detailed later in this document. The address validation signal ATD is provided to the address buffer 340 and to the read amplifier 370. The sensing signal SEN is provided to the polarization circuit 360. The data latching signal Dlatch is provided to the read amplifiers 370.

The address buffer 340 receives the address of the data to be read from an address bus connected to the memory controller 700. The address can be multiplexed by the CPU 100, and can be demultiplexed by said memory controller, as well known by a person skilled in the art. In this document, the full address is received in parallel by the address buffer 340 from the memory controller 700. The address buffer 340 memorizes the full address at the beginning of the read operation triggered by the address validation signal ATD and till the end of the read operation for providing different address segments to several elements of the memory 300. A first segment is the block address that controls the powering of the memory block into which the reading operation is to be performed. A second segment is the word address which is sent to the word line decoder 350 for selecting one word line WLj. A third segment is the bit line address which is sent to the bit line decoder 380 for selecting one or more bit lines that correspond to the read data word, depending on the number of bits that are corresponding to a data word.

The word line decoder 350 is a demultiplexer circuit that provides an active level to one word line WLj corresponding to the word address provided by the address buffer 340 while the other word lines are at an inactive level. The word line decoder 350 selects the reading of all the memory cells MCj,1 to MCj,n connected to the selected word line WLj.

The polarization circuit 360 provides a same and constant current to all the bit lines BL1 to BLn when the sensing signal SEN is active. The constant current polarizes the bit lines BL1 to BLn and participates to the charging and discharging of said bit lines BL1 to BLn during the reading of the memorized value of the selected memory cells MCj,1 to MCj,n connected to the bit lines BL1 to BLn.

The read amplifiers 370 comprise amplification circuits connected to bit lines for reading the value of the selected cells after a reading time. In view to read the value, the read amplifiers 370 charge the bit line to the second reference voltage Vpbl under the control of the address validation signal ATD. Then, the bit lines are charged or discharged during a reading time, and the read values are latched by the data latching signal Dlatch.

The bit line decoder 380 is a multiplexer connected between the read amplifiers 370 and the memory cells MCj,i for selecting the bit lines to be read. With such a selection of bit lines, the number of read amplifiers 370 can be reduced to the number of bits of a data word instead of having as many amplifiers as bit lines. Such a selection can also enable to reduce the size of the polarization circuit 360. The attack detector 390 receives the first reference voltage Vref for monitoring a polarization current of the bit lines BLi. The attack detector 390 provides an alarm signal ALARM on an output terminal when the first reference voltage Vref corresponds to an abnormal polarization current.

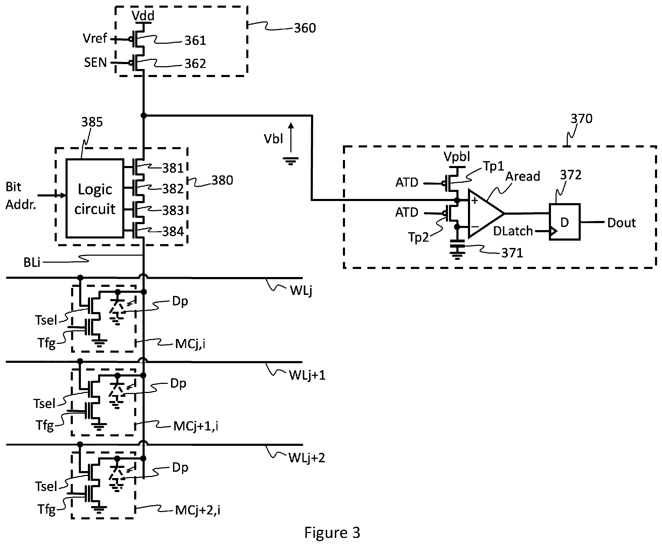

Other memory structures can implement the invention. The place of the element can be moved for optimizing the placing without changing the function. In view to explain how is made a reading operation with and without attack, the figure 3 details the different elements of the memory 300 in relation with one bit line BLi. As it can be seen on the figure 3, the elements of figure 2 are not located at the same places and enable to reduce the size of the polarization circuit 360.

For simplifying the drawings, only three word lines WLj, WLj+1 and WLj+2 are represented but, as well known by a person skilled in the art, the number m of word lines is much higher, for example m can be equal to 2¹⁰. The polarization circuit 360, the read amplifiers 370, and the bit line decoder 380 are limited to their components connected only to one bit line BLi.

The bit line decoder 380 comprises decoding transistors 381 to 384 serially mounted between the selected bit line BLi and the read amplifiers 370. The bit line decoder 380 comprises a logic circuit 385 that decodes the bit line address for controlling said decoding transistors 381 to 384. A person skilled in the art will understand that the polarization circuit 360 and the read amplifiers 370 are also connected to other bit lines through other decoding transistors (not shown) that are unselected by the bit line decoder 380. In addition, the polarization circuit 360, the read amplifiers 370, the decoding transistors 381 to 384 are repeated for each group of bit lines corresponding to another bit of the data which is read simultaneously.

As it can be seen on figure 3, the polarization circuit 360 comprises a mirror transistor 361 and a sensing transistor 362. The source of the mirror transistor 361 is connected to the supply voltage while its gate is connected to an input of the polarization circuit 360 receiving the first reference voltage Vref. The mirror transistor 361 is identical to a transistor located into the reference generator 320 for mirroring a reference current used for polarizing the bit line BLi at a constant current. The channel of the sensing transistor 362 is connected between the bit line BLi and the drain of the mirror transistor 361. The sensing transistor 362 is driven by the sensing signal SEN in such a way to provide the constant current to the bit line BLi only when the sensing signal SEN is active at a low level.

The read amplifiers 370 comprise a differential amplifier Aread, first and second preload transistors Tp1 and Tp2, a capacitor 371 and a latch 372 of D type. The differential amplifier Aread comprises two inputs and provides at its output a signal corresponding to the amplified difference between its inputs. A drain of the first preload transistor Tp1 and a source of the second preload transistor Tp2 are connected to one of the inputs of the differential amplifier Aread. A drain of the second preload transistor Tp2 is connected to the other of the inputs of the differential amplifier Aread. A source of the first preload transistor Tp1 is connected to the reference generator for receiving the second reference voltage Vpbl. The capacitor 371 is connected between the drain of the second preload transistor Tp2 and the ground of the memory circuit 300. The gates of the first and second preload transistors Tp1 and Tp2 both receive the address validation signal ATD for charging the capacitor 371 and the bit line BLi to the second reference voltage Vpbl when the address validation signal ATD is active. The latch 372 is connected at the output of the differential amplifier Aread for latching the read data under the control of the data latching signal Dlatch.

Each memory cell MCj,i comprises a floating gate transistor Tfg and a selection transistor Tsel. A gate of the selection transistor Tsel is connected to the word line WLj. A drain of the selection transistor Tsel is connected to the bit line BLi. A source of the selection transistor Tsel is connected to the drain of the floating gate transistor Tfg. A source of the floating gate transistor Tfg is connected to a ground voltage. The gate of the floating gate transistor Tfg is used for erasing and programming the bit memorized by the floating gate transistor and can be unconnected or can be polarized with a reading voltage for adjusting the current in the memory cell MCj,i during the reading operation. The memory cell MCj,i memorizes a bit value corresponding to a quantity of charges accumulated in the floating gate of the floating gate transistor Tfg. The value "0" or "1" of a memorized bit can be arbitrary associated to the fact that the floating gate is charged or discharged. In the present document the bit value "0" corresponds to a charged floating gate.

In addition, the selection transistor Tsel of each cell being a N-channel transistor made on a P-substrate, a parasitic diode Dp is reverse connected between the bit line BLi and the ground voltage. This parasitic diode Dp is normally always blocked and corresponds electrically to a small capacitor. The small capacitor multiplied by the number of memory cells MCj,i connected to the bit line BLi defines the total capacitance of the bit line BLi.

The person skilled in the art knows that such kind of memory is sized to be small with a low consumption. The size of the transistors constituting the memory cells MCj,i limits the current flowing through the memory cells and defines the global capacitance of the bit line BLi. In addition, each memory cell MCj,i, can have a current leakage, and a global current leakage must be taken into account. As an example, if the global current leakage is around 1,5 µA, the floating gate transistor (Tfg) can be sized for enabling to pass a current of 11,5 µA, while the polarization circuit 360 provides a constant current of 6,5 µA, in such a way that the bit line can be charged or discharged with a current of +/- 5 µA. The time for totally charging or discharging the bit line BLi depends on the number of cells connected to the bit line and can be around 40 ns for a complete charging with 2¹⁰ memory cells connected to one bit line. For preloading the bit line, the first preload transistor Tp1 (which are in lower number than memory cells) can be much larger for reducing the preload time for example to 2 ns.

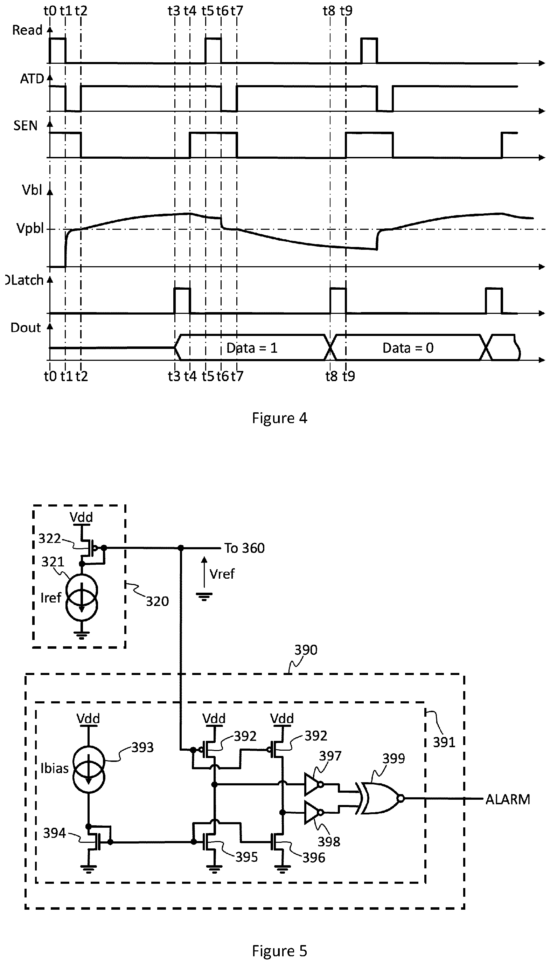

Before detailing the functioning of the attack detector 390, a normal reading operation is detailed in relation with figure 4. For reading a data, the address bus of the non-volatile memory 300 should be charged by the memory controller 700 with an address corresponding to a data to be read, as an example the data to be read comprises a bit located in the memory cell MCj,i. Then the memory controller 700 activates the reading signal Read at time t0 for indicating to the non-volatile memory 300 that a read operation must be performed. In response to the reading signal Read, the synchronization circuit 330 activates the address validation signal ATD at a time t1 till a time t2. As an example, time t1 can be set 2 ns after time t0 and time t2 can be set 2 ns after time t1. The activation of the address validation signal ATD causes the address buffer 340 to memorize the address at time t1. The address buffer 340 provides immediately at the time t1 the block address to switch on the selected memory block, and the bit address corresponding to the bit line BLi for connecting the selected bit line BLi through the decoding transistors 381 to 384.

During the activation of the address validation signal ATD, the first and second preload transistor Tp1 and Tp2 are switched on and the bit line BLi is preloaded to the second reference voltage Vpbl. It should be noted by the person skilled in the art that the channel width of the first preload transistor Tp1 must be sized for driving the bit line voltage at the second reference voltage Vpbl before the time t2.

At time t2, the address buffer 340 provides the word address that selects the word line WLj. The selection transistor Tsel of memory cell MCj,i switches to a conducting state at this moment.

At time t2, the synchronization circuit 330 deactivates the address validation signal ATD and activates sensing signal SEN. The deactivation of the address validation signal ATD blocks the first and second preload transistors Tp1 and Tp2. The activation of the sensing signal SEN connects the mirror transistor 361 to the bit line BLi through the sensing transistor 362. Considering that the floating gate of the floating gate transistor Tfg of memory cell MCj,i is discharged, the floating gate transistor Tfg of the selected memory cell MCj,i is in open circuit. The stabilized current provided by the mirror transistor 361 can charge the capacitance of the bit line BLi, increasing the bit line voltage Vbl.

At time t3, the synchronization circuit 330 activates the data latching signal Dlatch. The bit line BLi being at a voltage higher than the second reference voltage Vpbl memorized by the capacitor 371, the output of the differential amplifier is at high level, and the latch 372 memorizes and provides at its output a bit value equal to "1". It should be noted that the time t3 is set to a value corresponding to a sufficient time for significatively charging or discharging the bit line for having a good reading of the cell level, but it is not necessary to wait a complete charging or discharging of the bit line. As an example, time t3 can be set to 20 ns after time t2 for warranting that the charging or discharging of bit line enables to have a good reading whatever the wear of the floating gate transistors. At a time t4, after time t3, for example 1 ns later, the synchronization circuit 330 deactivates the sensing signal SEN and a new reading operation can be initiated by the memory controller 700, presenting a new address, as an example the data to be read comprises a bit located in the memory cell MCj+1,i and containing a "0" value. The memory controller 700 activates the reading signal Read at time t5 for indicating to perform a new read operation. In response, the synchronization circuit 330 activates the address validation signal ATD at a time t6 till time t7.

The first and second preload transistors Tp1 and Tp2 preload the bit line BLi at the second reference voltage Vpbl before the time t7. At time t7, the address buffer 340 provides the word address that selects the word line WLj+1. The selection transistor Tsel of memory cell MCj+1,i switches to a conducting state at this moment.

At time t7, the synchronization circuit 330 deactivates the address validation signal ATD and activates sensing signal SEN. The deactivation of the address validation signal ATD blocks the first and second preload transistors Tp1 and Tp2. The activation of the sensing signal SEN connects the mirror transistor 361 to the bit line BLi through the sensing transistor 362. Considering that the floating gate of the floating gate transistor Tfg of memory cell MCj+1,i is charged, the floating gate transistor Tfg of the selected memory cell MCj,i is in a conducting state. The stabilized current provided by the mirror transistor 361 is driven to the ground together with the charges of the bit line BLi, decreasing the bit line voltage Vbl.

At time t8, the synchronization circuit 330 activates the data latching signal Dlatch. The bit line BLi being at a voltage lower than the second reference voltage Vpbl memorized by the capacitor 371, the output of the differential amplifier is at low level, and the latch 372 memorizes and provides at its output a bit value equal to "0". Another read operation can be performed after a time t9 corresponding to a deactivation of the sensing signal SEN.

In MOSFET technology, all the transistors comprise PN junctions between the substrate (or the well) and the drain or source. Classically all the PN junctions are reverse polarized in such a way these PN junctions are blocked. A laser or a radiative attack has the effect to make passant the PN junctions touched by the attack. If a laser attack is made on the reference generator 320, the reference of constant current provided by the polarization circuit 360 will be affected and the constant current can more or less increase or decrease, depending on which transistors are touched by the laser attack.

A floating gate transistor Tfg can be sized for passing a current of 11,5 µA when its floating gate is charged and is normally blocked when the floating gate is discharged. In practice, a floating gate transistor wears out through charging and discharging cycles. Even if the floating gate is discharged, remanent charges can pass a current of the order of 0,5 µA instead of having a blocked transistor. The charging of the floating gate can also open the channel for a current lower than expected. The constant current normally compensates for the wear of the floating gate transistor and the read amplifier can perform a correct reading even if the charge or the discharge of the bit line is not optimal. But, if the constant current is too low, the bit line can be discharged instead of being charged and if the constant current is too high, the bit line can be charged instead of being discharged, causing reading errors.

The figure 5 details a preferred embodiment of the attack detector 390 according to the invention. On the figure 5 is also present the part of the reference generator 320 providing the first reference voltage Vref. Typically, the reference generator 320 comprises a stabilized current source 321 that provides a reference current Iref which is equal to the constant current polarizing the bit lines BLi. The stabilized current source 321 can be of any type known by a person skilled in the art. The reference generator comprises an output transistor 322 identical to the mirror transistor 361 and having its source connected to the supply voltage Vdd, its drain and its gate connected to the reference source 321. The output of the reference generator 320 corresponds to the gate of the output transistor 322 that provides the first reference voltage Vref to the polarization circuit 360.

The attack detector 390 comprises a detection circuit 391 which is physically located far from the reference generator 320 in such a way to make it more difficult for a hacker to identify it. The detection circuit 391 comprises two copy transistors 392 identical to the mirror transistor 361. The sources of the copy transistors 392 are connected to the supply voltage Vdd while the gates of the copy transistors 392 receive the first reference signal Vref in such a way to reproduce the constant current.

The attack detector 391 further comprises a reference current source 393, a first transistor 394, a second transistor 395, a third transistor 396, a first inverter 397, a second inverter 398, and an output gate 399. The reference current source 393 is of any type capable of providing a stabilized current that is used in the detection circuit as a current reference. This source can be connected to the ground and the supply voltage Vdd through the channel of the first transistor 394. The drain and the gate of the first transistor 394 being connected to the gates of the second and third transistor 395 and 396. The sources of the first and second transistors 395 and 396 are connected to the ground while the drains of the first and second transistors 395 and 396 are each connected to the drain of one copy transistor 392.

The man of the art can note that on the figure 5 P-channel transistors are used for copy transistors 391 and N-channel transistors are used for the first to third transistors 394 to 396. This choice is because, in general case, P-channel transistors are used for the output transistor 322 and for mirror current 361. In case N-channel are used for providing the current to the bit line, the copy transistor should be N-channel transistors and the first to third transistors should be P-channel transistors; the supply and ground voltage should be of course inverted.

The first inverter 397 has an input connected to the node between the second transistor 395 and one of the copy transistors 392. The second inverter 398 has an input connected to the node between the third transistor 396 and one of the copy transistors 392. The output gate 399 is an XNOR gate having two inputs and one output. The inputs of the output gate 399 are respectively connected to the outputs of the first and second inverter 397 and 398. The reference current source 393, the first and second transistors 394 and 395 and the first inverter 397 form a first current comparator. The reference current source 393, the first and third transistors 394 and 396 and the second inverter 398 form a second current comparator.

For verifying that the constant current is not abnormal, the detection circuit verifies that the constant current is in a correct range of current. To that way the first current comparator compares the constant current with a low current threshold while the second comparator circuit compares the constant current with a high current threshold. The low and high current threshold are defined by the sizing of the reference current source 393 and of the first to third transistors 394 to 396.

As an example, the reference current source 393 can be sized for providing a reference current equal to the constant current in normal condition, the first transistor 394 can have a first channel width, the second transistor 395 can have a second channel width lower than the first channel width, and the third transistor 396 can have a second channel width higher than the first channel width.

In a normal condition, the second transistor 395 limits the current and the copy transistor 392 pulls the input voltage of the first inverter 397 to the supply voltage causing the output of the first inverter 397 to be low level while the other copy transistor 392 limits the current in its branch and the third transistor 396 pulls the input voltage of the second inverter 398 to the ground voltage causing the output of the second inverter 398 to be high level. The inputs of the output gate 399 being at different level, its output is at low level, the alarm signal ALARM being inactivated.

If a laser attack causes an increase of the constant current higher than the high current threshold, the output of the first inverter 397 remains at low level, but the third transistor 396 limits the current and the copy transistor 392 pulls the input voltage of the second inverter 398 to the supply voltage causing the output of the second inverter 398 to be low level, The inputs of the output gate 399 being at a same level, its output is at high level, activating the alarm signal ALARM.

If a laser attack causes a decrease of the constant current lower than the low current threshold, the output of the second inverter 398 remains at high level, but the copy transistor 392 limits the current in the branch of the second transistor 395 and the second transistor 395 pulls the input voltage of the first inverter 397 to the ground voltage causing the output of the second inverter 397 to be high level. The inputs of the output gate 399 being at a same level, its output is at high level, activating the alarm signal ALARM.

The person skilled in the art can understand that the low and high current thresholds enable to compensate an eventual error between the reference source 321 and the reference current source 393. Nevertheless, it is also possible to have a larger range of current for detecting only laser attack that can create an error of reading. As another example, the reference current source 393 can be sized for providing a reference current equal to 2 µA, the first and second transistors 394 and 395 can have a same channel width, and the third transistor 396 can have a channel five times higher than the channel of the first transistor, fixing the low current level at 2 µA and the high current threshold at 10 µA.

The person skilled in the art knows the relation between current and voltage. It is possible to have a single copy transistor for copying the constant current and for providing the constant current to a resistor and two voltage comparators can compare the voltage at the terminals of the resistor. It is also possible to compare directly the first reference voltage to two voltage thresholds without using copy transistors. Nevertheless, it was preferred to have two current comparator circuits for comparing the constant current because it appears to be more accurate than the solution using voltage comparators.

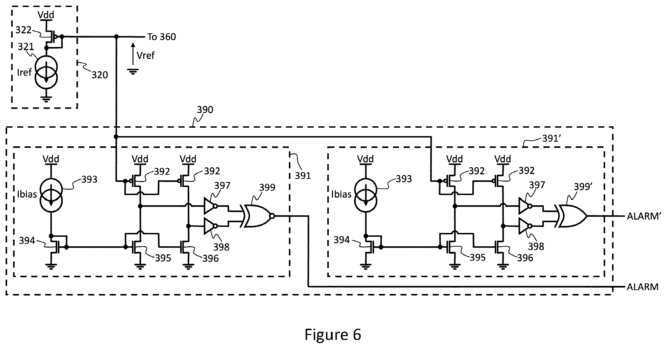

The use of one detection circuit 391 is sufficient for detecting a laser attack on the reference generator 320. Nevertheless, for preventing the neutralization of the attack detector 390 by a hacker it can be preferred to duplicate the detection circuit 391. The figure 6 shows a variant of the attack detector 390 comprising a first detection circuit 391 and a second detection circuit 391'. The first and second detection circuits are preferably both located far from the reference generator 320 and far from each other, preventing their neutralization. The first detection circuit 391 can be identical to the detection circuit of figure 5. The second detection circuit 391' can be identical to the first detection circuit 391 with an exception on the output gate 399'. Having two detection circuits 391 and 391' enables to have complementary alarm signals ALARM and ALARM'. So, the output gate 399' of the second detection circuit 391' differs and is an XOR gate instead of an XNOR gate.

Other variants are possible, as an example, the use of two detection circuits can allow to have different current ranges of detection on the detection circuits for providing two alarm signals. A close current range can be used for the detection of an attack that does not cause reading errors and a wide current range can be used for the detection of an attack that causes reading errors.

The person skilled in the art can also imagine many variants of the invention without departing from the scope of the annexed set of claims.

## Claims

1. A method for detecting a reading error caused by a photoelectric or radiative attack of a non-volatile memory having memory cells (MCj,i) connected to at least one bit line (BLi), and comprising each a floating gate transistor (Tfg), wherein the reading of a memory cell (MCj,i) is made by pre-charging a bit line (BLi) to a preload voltage (Vpbl) and comparison of the bit line voltage (Vbl) to this preload voltage (Vpbl) after a reading time during which a selected cell (MCj,i) charges or discharges the bit line (BLi) polarized by a constant current, the constant current being provided by a reference generator (320), **characterized in that** the detection of the photoelectric or radiative attack is made by a monitoring of the constant current, and wherein an alarm signal (ALARM) is provided when an abnormal constant current is detected.

2. The method of claim 1 wherein the monitoring of the constant current is made by a comparison of the constant current with a high current threshold and with a low current threshold, the low current threshold being lower than the high current threshold and wherein the alarm signal is provided when the constant current is not comprised between the high current threshold and the low current threshold.

3. A non-volatile memory circuit (300) comprising a plurality of memory cells (MC1,1 to MCm,n), a plurality of bit lines (BL1 to BLn) and a plurality of word lines (WL1 to WLm), each memory cell (MCj,i) comprising a floating gate transistor (Tfg) for memorizing a bit value and being located at the intersection of a bit line (BLi) and of a word line (WLj), said non-volatile memory circuit (300) comprising a polarization circuit (360) for polarizing the bit lines (BLi) with a constant current, a reference generator (320) providing a reference signal (Vref) to the polarization circuit (360) for generating the constant current, and reading amplifiers (370) connected to bit lines (BLi) for reading a value of memory cells (MCj,i) selected by one of the word lines (WLj), **characterized in that** it further comprises an attack detector (390) comprising at least one detection circuit (391) having an input terminal receiving the reference signal (Vref) to monitor the constant current and for providing an alarm signal (ALARM) on an output terminal when the reference signal (Vref) indicates that the constant current corresponds to an abnormal constant current.

4. The non-volatile memory circuit of claim 3, wherein the polarization circuit (360) comprises at least one mirror transistor (361) having a gate receiving the reference signal (Vref) and a channel connected to the bit line (BLi) for providing the constant current, wherein the detection circuit (391) comprises at least one copy transistor (392) identical to the mirror transistor (361) for reproducing the constant current, wherein the detection circuit (391) is configured for comparing the constant current with a high current threshold and with a low current threshold, the low current threshold being lower than the high current threshold, and wherein the alarm signal (ALARM) is provided when the constant current is not comprised between the high current threshold and the low current threshold.

5. The non-volatile memory circuit of claim 4, wherein the detection circuit (391) comprises two copy transistors (392) and first and second comparator circuits (393 to 398), each of the first and second comparator circuits being connected to one of the copy transistors (392), and wherein the first comparator circuit (393, 394, 395, 397) compares the constant current with the low current threshold while the second comparator (393, 394, 396, 398) circuit compares the constant current with the high current threshold.

6. The non-volatile memory circuit of claim 5, wherein the detection circuit (391) comprises a logic gate (399) having two inputs and one output, the two inputs being respectively connected to outputs of the comparator circuits (393 to 398), and the output providing the alarm signal when the first comparator circuit indicates that the constant current is lower than the low current threshold or when the second comparator circuit indicates that the constant current is higher than the high current threshold.

7. The non-volatile memory circuit according to one of the claims 3 to 6, wherein the detection circuit (391) is located far from the reference circuit (320).

8. The non-volatile memory circuit according to one of the claims 3 to 6, wherein the attack detector (390) comprises two detection circuits (391, 391').

9. The non-volatile memory circuit of claim 8, wherein the output signals (ALARM, ALARM') of the detection circuits (391, 391') are complementary signals.

10. The non-volatile memory circuit of claim 8 or 9, wherein each of the detection circuits (391, 391') is located far from the reference circuit (320), and wherein the detection circuits (391, 391') are located far from each other.
